# EUROPEAN PATENT APPLICATION

(11) **EP 4 040 614 A1**
(43) Date of publication of application: **10.08.2022**
(21) Application number: 20872052.4
(22) Date of filing: 29.09.2020
(51) Int. Cl.: H01S 5/022, H01L 23/02

(54) **PACKAGE FOR MOUNTING PHOTONIC DEVICE, AND ELECTRONIC DEVICE**

(30) Priority: 30.09.2019 JP 2019178931
(71) Applicant: Kyocera Corporation, Kyoto-shi Kyoto 612-8501 (JP)
(72) Inventor: KITAGAWA, Akihiko, Kyoto-shi, Kyoto 612-8501 (JP); KIMURA, Takashi, Kyoto-shi, Kyoto 612-8501 (JP)
(74) Representative: Viering, Jentschura & Partner mbB Patent- und Rechtsanwälte
(86) International application number: PCT/JP2020/036910
(87) International publication number: WO 2021/065909

(57) **Abstract**

A photonic-device-mounting package has a base having plural mounting portions. Each of the plural mounting portions has a first mounting portion on which a light-emitting device is mounted and a second mounting portion on which an optical component is mounted, the second mounting portion being at a position in a light emission direction of the light-emitting device. The base has a first wall disposed between two mounting portions arranged next to one another in the light emission direction, the first wall having a height larger than the height of the first mounting portion.

## Description

### TECHNICAL FIELD

The present disclosure relates to a photonic-device-mounting package and an electronic apparatus.

### BACKGROUND ART

Japanese Unexamined Patent Application Publication No. 2017-208484 discloses a light-emitting apparatus having a single package in which a large number of issuing devices are disposed. In the above-described light-emitting apparatus, plural pairs of light-emitting devices (30) and mirrors (50) are arranged, in a matrix shape, on one surface (12A) of the package.

### SUMMARY OF INVENTION

A photonic-device-mounting package according to the present disclosure has
a base having plural mounting portions.

Each of the plural mounting portions has a first mounting portion on which a light-emitting device is mounted and a second mounting portion on which an optical component is mounted,
the second mounting portion being at a position in a light emission direction of the light-emitting device.
The base has
a first wall disposed between two mounting portions arranged next to one another in the light emission direction, the first wall having a height larger than the height of the first mounting portion.

An electronic apparatus according to the present disclosure has:
the above-described photonic-device-mounting package;
plural light-emitting devices mounted on the plural first mounting portions;
plural optical components mounted on the plural second mounting portions; and
a lid joined to the photonic-device-mounting package.

### BRIEF DESCRIPTION OF DRAWINGS

[Fig. 1] Fig. 1 is a plan view of a photonic-device-mounting package and an electronic apparatus according to a first embodiment of the present disclosure.
[Fig. 2] Fig. 2 is a vertical sectional view taken along line A-A of Fig. 1.
[Fig. 3] Fig. 3 is a vertical sectional view taken along line B-B of Fig. 1.
[Fig. 4] Fig. 4 illustrates the beam profile of a light-emitting device.
[Fig. 5] Fig. 5 is a plan view of a photonic-device-mounting package and an electronic apparatus according to a second embodiment.
[Fig. 6] Fig. 6 is a vertical sectional view taken along line C-C of Fig. 5.
[Fig. 7] Fig. 7 is a plan view of a photonic-device-mounting package and an electronic apparatus according to a third embodiment.
[Fig. 8] Fig. 8 is a vertical sectional view taken along line D-D of Fig. 7.

### DESCRIPTION OF EMBODIMENTS

Hereinafter, embodiments of the present disclosure will be described with reference to the drawings.

### (First Embodiment)

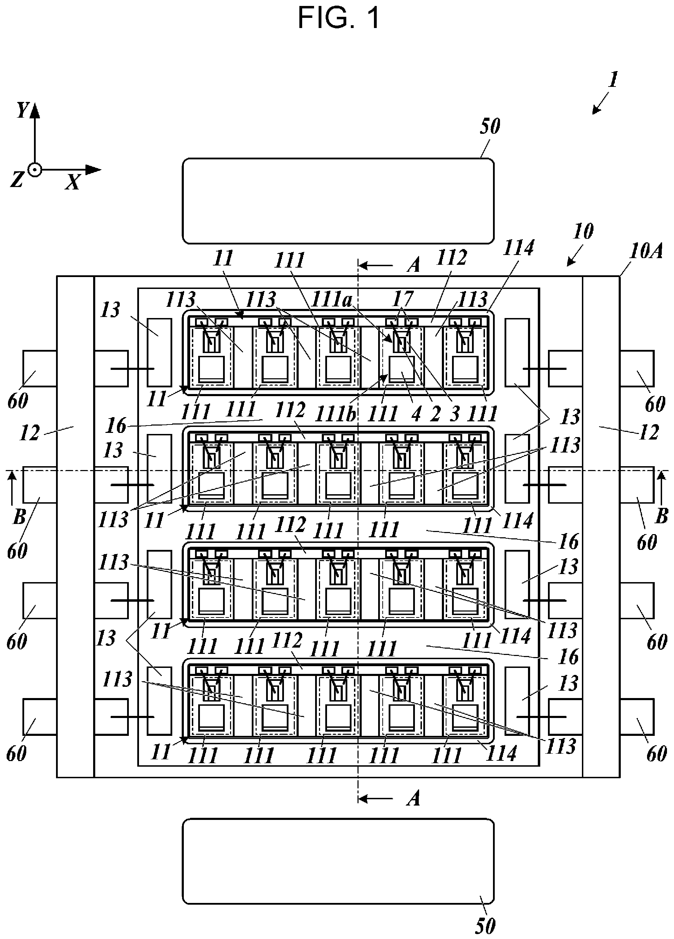

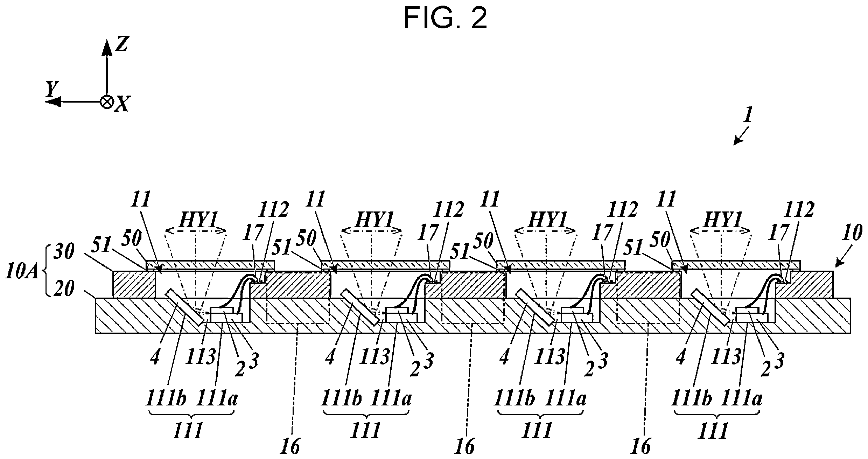

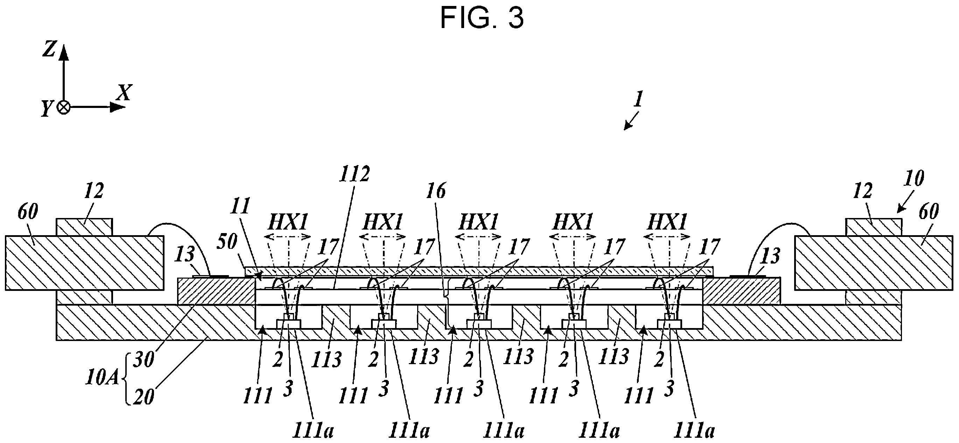

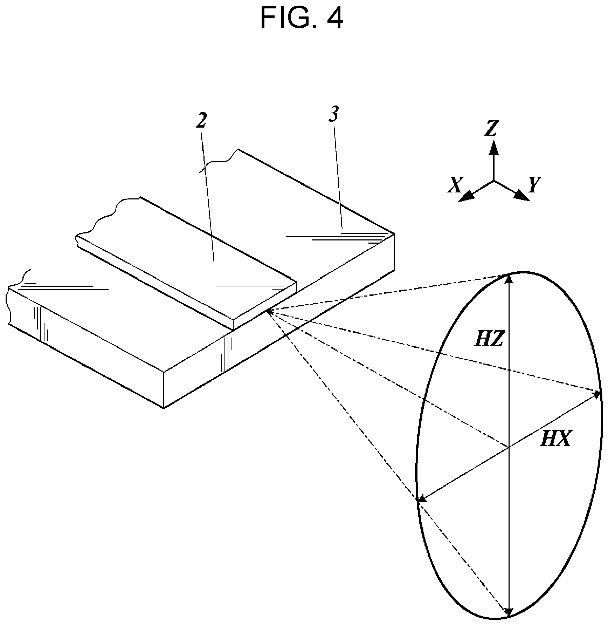

Fig. 1 is a plan view of a photonic-device-mounting package and an electronic apparatus according to a first embodiment of the present disclosure. For brevity. In Fig. 1, references for some of the plural constituents identical to one another are omitted. Fig. 2 is a vertical sectional view taken along line A-A of Fig. 1. Fig. 3 is a vertical sectional view taken along line B-B of Fig. 1. Fig. 4 illustrates the beam profile of a light-emitting device. Hereinafter, directions are given as follows. The Z direction is directed vertically upward, and the X direction and the Y direction are the horizontal directions that are orthogonal to one another. However, the directions may differ from the directions if an electronic apparatus 1 is used. The Y direction corresponds to the outgoing direction of light from a light-emitting device 2 (light emission direction) and also corresponds to the direction in which a pair of light-emitting device 2 and optical component 4 are arranged.

A photonic-device-mounting package 10 of the first embodiment has a base 10A, plural lids 50, and plural connection terminals 60. The electronic apparatus 1 is configured by plural light-emitting devices 2 and plural optical components 4 being mounted in the photonic-device-mounting package 10.

The base 10A has plural mounting portions 111 arranged in the X direction and in the Y direction to have a matrix shape. A pair of light-emitting device 2 and optical component 4 is mounted on each of the mounting portions 111. The base 10A further has a first wall 16 positioned between two mounting portions 111, of the plural mounting portions 111, arranged next to one another in the Y direction.

The base 10A, more specifically, has plural recesses 11 opened to the upper surface side, a terminal-supporting portion 12 supporting plural connection terminals 60, plural external connection pads 13 that are electrically connected to the connection terminals 60, plural frame portions 114 to which the respective plural lids 50 are joined, and plural first walls 16 serving as partitions between the plural recesses 11.

The plural recesses 11 whose longitudinal direction is parallel to the X direction are arranged in the Y direction. In each of the recesses 11, plural mounting portions 111 are arranged in the X direction. Each of the recesses 11 further includes a step portion 112 extending in the X direction and used for wiring connection. Such step portions 112, with the plural mounting portions 111, are arranged in the Y direction. Plural pairs of connection pads 17 are disposed on the step portion 112 so as to correspond to the respective plural mounting portions 111. The connection pads 17 are each a metal layer and positioned on an upper surface of the step portion 112.

Each of the mounting portions 111 has a first mounting portion 111a on which the light-emitting device 2 is mounted, with a submount 3 interposed therebetween, and also has a second mounting portion 111b on which the optical component 4 is mounted. The plural pairs of connection pads 17 corresponding to plural first mounting portions 111a are disposed on the step portion 112. One first mounting portion 111a, one second mounting portion 111b, and one pair of connection pads 17 that correspond to one another are arranged in the Y direction. The second mounting portion 111b is at a position beside the first mounting portion 111a in the light emission direction of the light-emitting device 2.

An inner bottom surface of the first mounting portion 111a may be perpendicular to the Z direction. An inner bottom surface of the second mounting portion 111b may have a surface inclined relative to the Z direction. The step portion 112 is disposed below the lid 50 and above the mounting portion 111. In the plural mounting portions 111, between two mounting portions 111 arranged next to one another in the X direction, there may be provided a partition 113 separating the two mounting portions 111 from one another. The partition 113 extends to a position in a middle-tier part not reaching the height of the lid 50 (refer to Fig. 3) .

Each of the frame portions 114 is a metal layer to which the lid 50 is joined, and the frame portion 114 is positioned in the upper surface of the base 10A so as to surround the opening of one recess 11. The plural lids 50 are joined to the frame portions 114 of the respective plural recesses 11 with respective joining members interposed therebetween to seal the inner areas of the recesses 11. Each of the lids 50 is, for example, a glass plate and has a light transmitting property.

The first wall 16 is made of a material not allowing light to pass therethrough. The first wall 16 has a height larger than the height of the first mounting portion 111a. The height of the first mounting portion 111a corresponds to the height of the space defined as a space in which the light-emitting device 2 is mounted. The first wall 16 may be at a position higher than the optical axis of the light-emitting device 2. The first wall 16 may be present to a position higher than the position at which the outgoing light from the light-emitting device 2 comes into contact with the optical component 4. The first wall 16 may be present to a position higher than the light-emitting device 2 and the optical component 4 that are disposed on the mounting portion 111. The first wall 16 may be present to a position higher than the upper surface of the step portion 112 having the connection pads 17. The first wall 16 may be present to a position as high as the lid 50 or a joining portion 51 (Fig. 2) for the lid 50.

The base 10A may have a first base portion 20 made of metal and a second base portion 30 having a frame shape and mainly made of an insulating material. The second base portion 30 corresponds to an upper part of the base 10A and is joined to an upper surface of the first base portion 20. The second base portion 30 has a through hole passing through in an up-and-down direction while the first base portion 20 has a recessed hole opened upward, and the through hole and the recessed hole may communicate with one another to form the recess 11. The step portion 112 is part of the second base portion 30. The first wall 16 is present over the first base portion 20 and the second base portion 30. The terminal-supporting portion 12 is part of the first base portion 20, is present in a region in which the terminal-supporting portion 12 does not overlap the second base portion 30 if viewed in the Z direction, and is present to a position higher than the second base portion 30. The terminal-supporting portions 12 are arranged on both edge portions, in the X direction, of the first base portion 20 between which a central region including the plural recesses 11 is positioned and jet out in the Z direction. However, the terminal-supporting portions 12 may also jet out at both edge portions, in the Y direction, of the first base portion 20 between which the central region positioned, so as to surround the central region in all directions (in the X direction and in the Y direction).

The first base portion 20 is made of a highly thermally conductive metal material such as copper or aluminium and can be formed by, for example, press forming. A portion of the second base portion 30 having a fundamental shape is made of a ceramic material such as sintered aluminum oxide (alumina ceramics), sintered aluminum nitride, sintered mullite, or sintered glass-ceramics. The second base portion 30 can be produced as follows. For example, a ceramic green sheet, which is a ceramic material before sintering, is formed into a predetermined shape by a processing method such as punching or molding, and the green sheet is sintered. The second base portion 30 may have, as conductors, for example, the external connection pad 13, the connection pad 17, an internal conductor, and the frame portion 114 that has a metal surface. The internal conductor electrically connects the external connection pad 13 and the connection pad 17 to one another inside the second base portion 30. The above-described conductors can be made as follows. A ceramic green sheet is coated with or filled with conductive paste at a predetermined position before the second base portion 30 is sintered, and the conductive paste, with the ceramic green sheet, is sintered. Note that the first base portion 20 may be made of a ceramic material similar to the ceramic material used for the second base portion 30. If being made of a ceramic material, the first base portion 20 can be formed by, for example, molding. If being made of sintered bodies of the same material, the first base portion 20 and the second base portion 30 may be formed into one body.

The light-emitting device 2 is a laser diode (semiconductor laser) and is disposed so as to emit laser light in the Y direction. As Fig. 4 illustrates, regarding the beam profile of the light-emitting device 2, extent HZ in the Z direction is larger than extent HX in the X direction. The submount 3 is interposed between the first mounting portion 111a and the light-emitting device 2 for the purpose of, for example, electrical connection to the light-emitting device 2 and the height adjustment of the light-emitting device 2. The light-emitting device 2 is connected to the connection pads 17 that are for wiring and are arranged next to the first mounting portion 111a, via a bonding wire and a wiring conductor of the submount 3. The light-emitting device 2 is joined to the submount 3, and the submount 3 is joined to the first mounting portion 111a.

The optical component 4 is a reflecting mirror and reflects, in the Z direction, the light emitted from the light-emitting device 2 in the Y direction. The optical component 4 is joined to the second mounting portion 111b. The optical component 4 has a plate shape, and the second mounting portion 111b may have a surface inclined relative to the Z direction. As the vertical sectional views of Fig. 2 and Fig. 3 illustrate, according to the beam profile of the light-emitting device 2 (Fig. 4), the light that has passed the optical component 4 has extent HY1 in the Y direction larger than extent HX1 in the X direction.

### <Description of Operation>

If a power supply voltage is applied to the plural connection terminals 60, the power supply voltage is supplied to the plural light-emitting devices 2 via the external connection pad 13, the wiring conductors in the second base portions 30, and the connection pads 17. Each of the plural light-emitting devices 2 performs laser oscillation by being supplied with the power supply voltage and emits laser light in the Y direction. The outgoing laser light is turned in the Z direction by the optical component 4 and is output outside through the lid 50.

As described above, the photonic-device-mounting package 10 and the electronic apparatus 1 of the first embodiment have the first wall 16 that is disposed between two mounting portions 111 arranged next to one another in the Y direction and has a height higher than the height of the first mounting portion 111a. Thus, in the Y direction in which the extent HY1 of light is large, it is possible to make it difficult for a stray light scattered before passing through the lid 50 to enter a neighboring mounting portion 111 and to be incident and absorbed into the neighboring light-emitting device 2. Accordingly, it is possible to reduce deterioration of the light-emitting device 2.

Moreover, according to the photonic-device-mounting package 10 and the electronic apparatus 1 of the first embodiment, the first wall 16 is positioned higher than the optical axis of the light-emitting device 2. Thus, it is possible to make it further difficult for the above-described stray light to enter a neighboring mounting portion 111, and it is thereby possible to reduce deterioration of the light-emitting device 2. Furthermore, the first wall 16 is present to a position as high as the lid 50 or the joining portion 51 (Fig. 2) for the lid 50. Thus, it is possible to make it further difficult for the above-described stray light to enter a neighboring mounting portion 111, and it is possible to reduce deterioration of the light-emitting device 2.

Moreover, according to the photonic-device-mounting package 10 and the electronic apparatus 1 of the first embodiment, the upper part of the base 10A is an insulator (the second base portion 30) having a frame shape. Thus, a stray light emitted from the light-emitting device 2 and scattered before passing through the lid 50 is absorbed into the insulator in the upper part of the base 10A. Accordingly, it is possible to make it further difficult for the stray light to enter a neighboring mounting portion 111, and it is possible to reduce deterioration of the light-emitting device 2.

Moreover, according to the photonic-device-mounting package 10 and the electronic apparatus 1 of the first embodiment, the connection pad 17 disposed in the recess 11, for electrical connection to the light-emitting device 2, is disposed on the step portion 112. Furthermore, the frame portion 114 having a metal surface to which the lid 50 is joined is disposed in the upper surface of the base 10A. The upper surface of the step portion 112 and the upper surface of the base 10A may be perpendicular to the Z direction. With the above-described configuration, many of the stray lights entering a region above the step portion 112 or many of the stray lights entering a region above the joining portion for the lid 50 are reflected outside the recess 11 by the connection pads 17 or the frame portion 114 to hardly enter a neighboring mounting portion 111. Thus, it is possible to make it difficult for the stray light to be incident and absorbed into a neighboring light-emitting device 2, and it is possible to reduce deterioration of the light-emitting device 2.

Moreover, according to the photonic-device-mounting package 10 and the electronic apparatus 1 of the first embodiment, the lid 50 positioned above the plural mounting portions 111 is a continuous body in the vertical section perpendicular to the Y direction (Fig. 3). The laser light that passes through the lid 50 does not greatly expand in the X direction, and it is thereby unlikely that a stray light will enter, along the lid 50, a neighboring mounting portion 111 in the X direction. Thus, as a continuous body, the lid 50 covering the upper side of the plural mounting portions 111 arranged next to one another in the X direction enables reduction in the number of components and simplification of an assembly process, while maintaining the effect of reducing deterioration of the light-emitting device 2.

### (Second Embodiment)

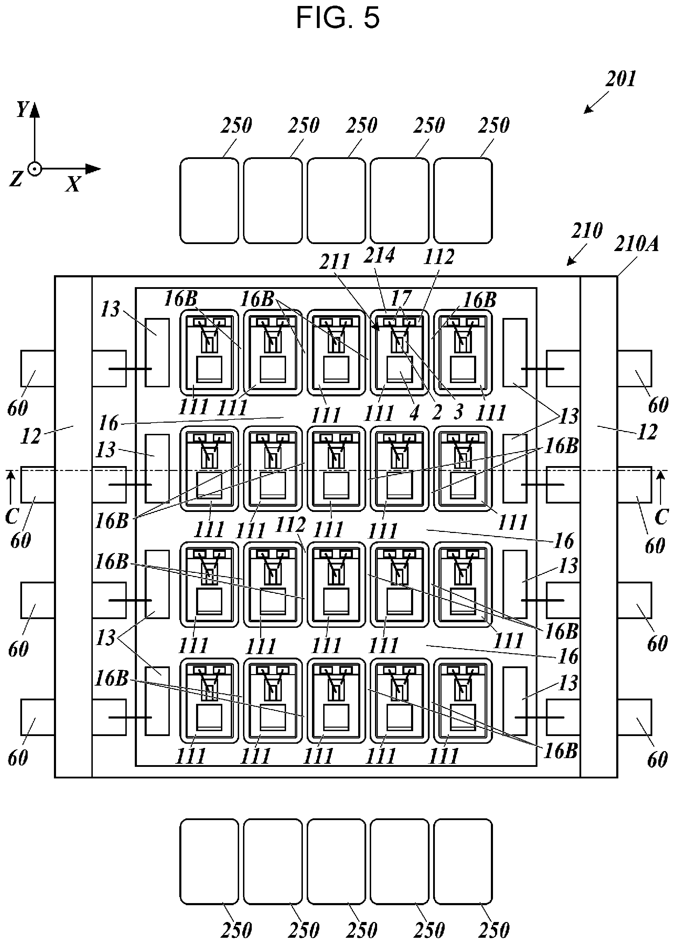

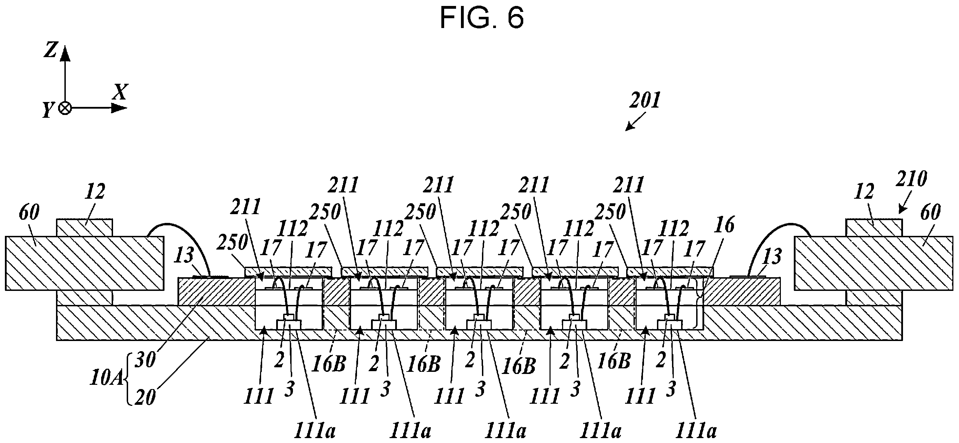

Fig. 5 is a plan view of a photonic-device-mounting package and an electronic apparatus according to a second embodiment. For brevity, in Fig. 5, references for some of the plural constituents identical to one another are omitted. Fig. 6 is a vertical sectional view taken along line C-C of Fig. 5.

A photonic-device-mounting package 210 and an electronic apparatus 201 of the second embodiment differ from those of the first embodiment mainly in that a base 210A is added with a second wall 16B positioned between two mounting portions 111 arranged next to one another in the X direction and between two step portions 112 arranged next to one another in the X direction. The constituents similar to those of the first embodiment are given the same references as those given in the first embodiment, and detailed descriptions of the constituents will be omitted.

The second wall 16B may have the same height as the first wall 16 extending in the X direction, and the second wall 16B and the first wall 16 may be formed into one body. Recesses 211 are separated from one another by the first wall 16 and the second wall 16B in the X direction and in the Y direction. Each of the recesses 211 has one mounting portion 111 and one step portion 112. A frame portion 214 to which a lid 250 is joined is a metal layer and surrounds the opening of the corresponding recess 211, and one lid 250 covers the opening of one recess 211. The second wall 16B is present over the first base portion 20 and the second base portion 30.

The photonic-device-mounting package 210 and the electronic apparatus 201 of the second embodiment have the second wall 16B disposed between two mounting portions 111 arranged next to one another in the X direction. Thus, a stray light emitted from the light-emitting device 2 and scattered before being output outside through the lid 250 hardly enters a neighboring mounting portion 111 in the X direction. Accordingly, intrusion and absorption of the stray light hardly occur due to the light-emitting device 2, and it is possible to reduce deterioration of the light-emitting device 2.

Moreover, according to the photonic-device-mounting package 210 and the electronic apparatus 201 of the second embodiment, the lids 250 are also separated from one another in the X direction. If a stress is generated between the base 10A and the lid 250 based on the difference in coefficient of thermal expansion, the stress increases according to a distance from the center of the lid 250. By the lids 250 being also separated from one another in the X direction, the stress generated in a joining portion between the lid 250 and the base 10A can be reduced, and it is thereby possible to improve the reliability of the hermetic structure of the recess 211.

Note that, regarding the photonic-device-mounting package 210 and the electronic apparatus 201 of the second embodiment, the lids 250 may also be connected to one another in the X direction to form a continuous body as in the case of the first embodiment.

### (Third Embodiment)

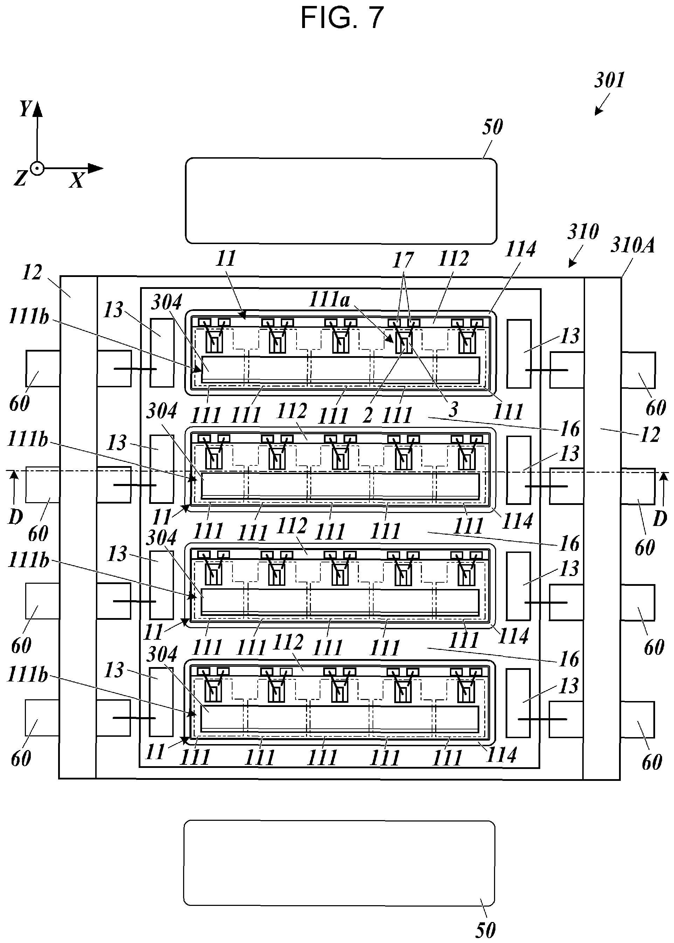

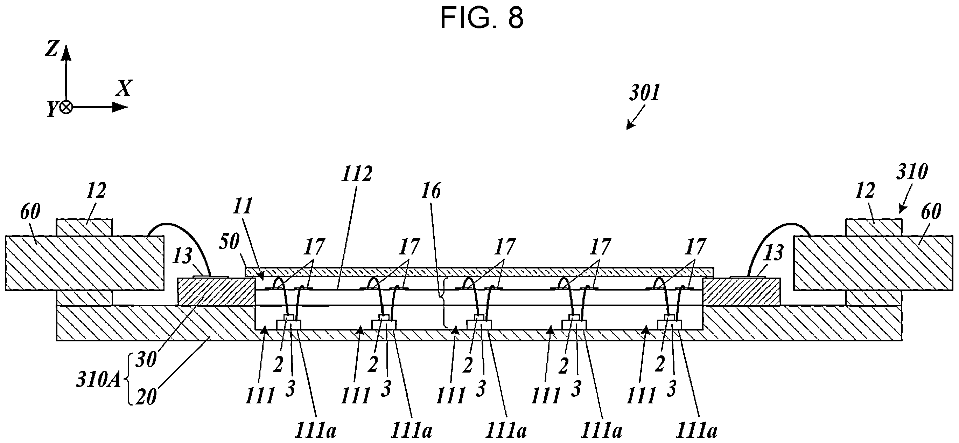

Fig. 7 is a plan view of a photonic-device-mounting package and an electronic apparatus according to a third embodiment. For brevity, in Fig. 7, references for some of the plural constituents identical to one another are omitted. Fig. 8 is a vertical sectional view taken along line D-D of Fig. 7. A photonic-device-mounting package 310 and an electronic apparatus 301 of the third embodiment differ from those of the first embodiment mainly in that an integrally formed optical component 304 is mounted over the plural mounting portions 111 arranged in the X direction. The constituents similar to those of the first embodiment are given the same references as those given in the first embodiment, and detailed descriptions of the constituents will be omitted.

The partition 113 of the first embodiment (refer to Figs. 1 to 3) is omitted from a base 310A of the third embodiment. The second mounting portion 111b on which the optical component 304 is mounted may be continuous over the plural mounting portions 111 in one recess 11. In one recess 11, such continuous second mounting portion 111b and the integrally formed optical component 304 occupy the range from the mounting portion 111 positioned in a negative-side end portion in the X direction in the recess 11 to the mounting portion 111 positioned in a positive-side end portion in the X direction in the recess 11.

As described above, the photonic-device-mounting package 310 and the electronic apparatus 301 of the third embodiment enable reduction in the number of components and simplification of an assembly process by the optical component 304 being formed as one body in the X direction. Moreover, by the optical component 304 being formed as one body in the X direction to increase the contact surface of the optical component 304 with the base 10A, it is possible to improve heat dissipation from the optical component 304 and to improve the joining strength of the optical component 304, and, due to the above-described improvement, it is thereby possible to stabilize the light output of the electronic apparatus 301. Because the extent of the light of the light-emitting device 2 is small in the X direction, even if the optical component 304 is formed as one body, a stray light is less likely to enter a neighboring mounting portion 111, and it is possible to maintain the state in which the light-emitting device 2 is hardly deteriorated by the stray light.

Note that, also in the case of the photonic-device-mounting package 310 and the electronic apparatus 301 of the third embodiment, a portion of the partition 113 of the first embodiment overlapping the second mounting portion 111b may be omitted, but a portion of the partition 113 adjacent to the first mounting portion 111a is not necessarily omitted.

The embodiments of the present disclosure have so far been described. However, the photonic-device-mounting package and the electronic apparatus of the present disclosure is not limited to those in the above-described embodiments. For example, the configuration in which the light-emitting device is a laser diode is described, as an example, in the above-described embodiments. However, for such a light-emitting device, various light-emitting devices having directivity, such as a light-emitting diode, may be used. In addition, the configuration in which the optical component is a reflecting mirror having a plate shape is described, as an example, in the above-described embodiments. However, such an optical component may also be a reflecting mirror having a reflecting surface and a joining surface that are not parallel to one another or may alternatively be a light-guiding member such as a prism. In addition to the above-described configurations, the details given in the embodiments, such as the detailed shape of the base, the sealing structure of the optical device and the optical component, and the electrical wiring structure, can appropriately be modified.

### INDUSTRIAL APPLICABILITY

The present disclosure is applicable to a photonic-device-mounting package and an electronic apparatus.

### REFERENCE SIGNS LIST

- 1, 201, 301: electronic apparatus
- 2: light-emitting device
- 3: submount
- 4, 304: optical component
- 10, 210, 310: photonic-device-mounting package
- 10A, 210A, 310A: base
- 11, 211: recess
- 16: first wall
- 16B: second wall
- 17: connection pad
- 111: mounting portion
- 111a: first mounting portion
- 111b: second mounting portion
- 112: step portion
- 114, 214: frame portion
- 20: first base portion
- 30: second base portion
- 50, 250: lid
- 51: joining portion

## Claims

1. A photonic-device-mounting package comprising:
a base having a plurality of mounting portions,
wherein each of the plurality of mounting portions has a first mounting portion on which a light-emitting device is mounted and a second mounting portion on which an optical component is mounted,
the second mounting portion being at a position in a light emission direction of the light-emitting device, and
wherein the base has
a first wall disposed between two mounting portions arranged next to one another in the light emission direction, the first wall having a height larger than a height of the first mounting portion.

2. The photonic-device-mounting package according to Claim 1,
wherein an upper part of the base is an insulator having a frame shape.

3. The photonic-device-mounting package according to Claim 1 or Claim 2,
wherein the base has an upper surface, a step portion, and a metal layer for wiring or for joining a lid,
the metal layer being positioned in or on the upper surface or the step portion.

4. The photonic-device-mounting package according to any one of Claims 1 to 3,
wherein the base has
a second wall disposed between two mounting portions arranged next to one another in a direction perpendicular to the light emission direction.

5. The photonic-device-mounting package according to any one of Claims 1 to 4,
wherein the base has a joining portion for a lid positioned above the plurality of mounting portions, and
wherein the first wall is present to a position as high as the joining portion.

6. An electronic apparatus comprising:
the photonic-device-mounting package according to any one of Claims 1 to 5;
a plurality of light-emitting devices mounted on the plurality of first mounting portions;
a plurality of optical components mounted on the plurality of second mounting portions; and
a lid joined to the photonic-device-mounting package.

7. The electronic apparatus according to Claim 6,
wherein the first wall in the photonic-device-mounting package is positioned higher than an optical axis of the light-emitting devices.

8. The electronic apparatus according to Claim 6 or Claim 7,
wherein the lid positioned above the plurality of mounting portions is a continuous body, in a vertical section perpendicular to a direction in which the first mounting portion and the second mounting portion are arranged.

9. The electronic apparatus according to any one of Claims 6 to 8,
wherein one body comprises the optical components mounted on the plurality of mounting portions, in a vertical section perpendicular to a direction in which the first mounting portion and the second mounting portion are arranged.
